# EUROPÄISCHE PATENTSCHRIFT

(11) **EP 3 990 303 B1**
(45) Veröffentlichungstag und Bekanntmachung des Hinweises auf die Patenterteilung: **02.12.2026**
(21) Anmeldenummer: 21726345.8
(22) Anmeldetag: 07.05.2021
(51) Int. Cl.: G06F 3/01, H03K 17/96, B60K 35/10, B60K 35/25

(54) **BEDIENELEMENT MIT EINER BEDIENOBERFLÄCHE UND EINEM VIBRATIONSAKTUATOR ZUR ERZEUGUNG EINER LOKAL FESTGELEGTEN VIBRATION AUF DER BEDIENOBERFLÄCHE**
CONTROL ELEMENT WITH A CONTROL SURFACE AND A VIBRATION ACTUATOR FOR GENERATING A LOCALLY DETERMINED VIBRATION ON THE CONTROL SURFACE
ÉLÉMENT DE COMMANDE COMPRENANT UNE SURFACE DE COMMANDE ET UN ACTIONNEUR DE VIBRATION POUR GÉNÉRER UNE VIBRATION DÉTERMINÉE LOCALEMENT SUR LA SURFACE DE COMMANDE

(30) Priorität: 30.06.2020 DE 102020117200
(43) Veröffentlichungstag der Anmeldung: 04.05.2022
(73) Patentinhaber: Marquardt GmbH, 78604 Rietheim-Weilheim (DE)
(72) Erfinder: HAUSMANN, Alexander, 78073 Bad Dürrheim (DE); GAISER, Siegbert, 72414 Rangendingen (DE); SCHWARZKOPF, Andreas, 78056 Villingen (DE)
(74) Vertreter: Staeger & Sperling Partnerschaftsgesellschaft mbB
(86) Internationale Anmeldenummer: PCT/EP2021/062099
(87) Internationale Veröffentlichungsnummer: WO 2022/002466

(56) Entgegenhaltungen:
- WO-A1-2020/078600
- WO-A1-2020/229000
- DE-A1- 102016 112 501
- US-A1- 2002 149 561

## Beschreibung

Die Erfindung betrifft ein Bedienelement mit einer Bedienoberfläche und einem Vibrationsaktuator zur Erzeugung einer lokal festgelegten Vibration auf der Bedienoberfläche.

Aus dem Stand der Technik ist es bekannt, dass Bedienoberflächen mit einem haptischen Feedback über Vibration ausgestattet werden. So kann beispielsweise eine erfolgreiche erfolgte Eingabe auf der Bedienoberfläche als positive Rückmeldung bestätigt werden. Hierfür wird meist ein Vibrationsaktuator unmittelbar an das die Bedienoberfläche bildende Bauteil befestigt, das beispielsweise ein Gehäuseteil oder eine Blende darstellt.

Die Vibration des Vibrationsaktuators wirkt dabei diffus auf die Bedienoberfläche, so dass keine klar definierte Eingabefläche mit der Vibration beaufschlagt wird und sich daraus ein Vibrations-Feedback auch über Bereiche hinaus ergibt, das von der Eingabefläche unabhängig ist. Dies ist insbesondere dann problematisch, wenn in der Bedienoberfläche mehrere Eingabestellen nebeneinander angeordnet sind und sich die Vibration diffus über einen nicht definierten Bereich verhält.

Der Erfindung liegt deshalb die Aufgabe zugrunde, ein Bedienelement bereit zu stellen, dessen Bedienoberfläche ein exakt definiertes Vibrations-Feedback in einem festgelegten Abschnitt der Bedienoberfläche liefert.

Diese Aufgabe wird durch die Merkmalskombination gemäß Patentanspruch 1 gelöst.

Erfindungsgemäß wird ein Bedienelement mit einer Bedienoberfläche auf einer Vorderseite und einer Hinterfläche auf einer zur Vorderseite gegenüberliegenden Rückseite des Bedienelements vorgeschlagen. Das Bedienelement weist einen Vibrationsaktuator auf, der wirkverbunden ist mit einem lokal begrenzten Abschnitt der Bedienoberfläche, so dass eine über eine Sensorik detektierte Berührung des lokal begrenzten Abschnitts der Bedienoberfläche eine Vibration des Vibrationsaktuators auslöst. Der lokal begrenzte Abschnitt bildet dabei eine Mensch-Maschine-Schnittstelle. Als Sensorik werden hierbei beispielsweise in der Technik bekannte kapazitive Sensoren verwendet. Der Vibrationsaktuator ist bei dem Bedienelement mittelbar über ein Hebelelement mit der Hinterfläche auf der Rückseite der Bedienoberfläche verbunden. Das Hebelelement überträgt eine Vibration des Vibrationsaktuators zur Hinterfläche des Bedienelements genau in den Bereich des lokal begrenzten Abschnitts der Vorderseite der Bedienoberfläche.

Durch die Verwendung des Hebelelements erfolgt eine Entkopplung des Vibrationsaktuators von dem die Bedienoberfläche stellenden Bauteil. Die Vibration des Vibrationsaktuators erfolgt nicht unmittelbar, sondern mittelbar über das Hebelelement auf den für das haptische Feedback vorgesehenen lokal begrenzten Abschnitt. Dabei wird die Vibration von dem Hebelelement zunächst rückseitig auf die Hinterfläche des die Bedienoberfläche bildenden Bauteils und anschließend durch das Bauteil hindurch auf die Bedienoberfläche übertragen.

Als Vibrationsaktuator können die in der Technik bekannten Aktuatoren verwendet werden, die beispielsweise Schwingungen mit 2-5mm Hub und einer Kraft von beispielsweise 10N ausüben.

Eine erfindungsgemäße Ausführungdes Bedienelements sieht vor, dass das Hebelelement einen Anlagenabschnitt aufweist, der zur Anlage an der Rückseite der Bedienoberfläche in dem lokal begrenzten Abschnitt der Bedienoberfläche ausgebildet ist und eine geometrische Abmessung aufweist, die dem lokal begrenzten Abschnitt der Bedienoberfläche entspricht. Ist beispielsweise der lokal begrenzte Abschnitt quadratisch geformt, wird auch der Anlagenabschnitt entsprechend quadratisch geformt.

Eine Weiterbildung des Bedienelements ist dabei dadurch gekennzeichnet, dass der Anlagenabschnitt flächig anliegend an der Rückseite des lokal begrenzten Abschnitts der Bedienoberfläche befestigt ist. Somit überträgt der gesamte Anlagenabschnitt die Vibration des Vibrationsaktuators auf den gesamten lokal begrenzten Abschnitt der Bedienoberfläche.

Bei dem Bedienelement ist ferner in einer günstigen Ausführung vorgesehen, dass der Vibrationsaktuator zu der Hinterfläche auf der Rückseite beabstandet angeordnet ist und eine Vibration des Vibrationsaktuators unmittelbar ausschließlich auf das Hebelelement einwirkt. Die durch den Vibrationsaktuator erzeugte Vibration erfolgt somit nicht auf die Hinterfläche, sondern direkt auf das Hebelelement, von dem aus es auf die Hinterfläche übertragen wird.

Das Bedienelement ist in einer erfindungsgemäßen Ausführungdadurch gekennzeichnet, dass das Hebelelement einen Halteabschnitt aufweist, an dem der Vibrationsaktuator befestigt gehalten ist. Das Hebelelement dient somit gleichzeitig als Halterung für den Vibrationsaktuator. Daran ist ferner vorteilhaft, dass die von dem Vibrationsaktuator erzeugten Vibrationen festgelegt nur auf das Hebelelement ausstrahlen und nicht andere Bauteile betreffen. Eine Geräuschbildung durch eine undefinierte Vibration von Bauteilen, die nicht vibrieren sollen, wird somit ausgeschlossen.

Das Bedienelement sieht in einer erfindungsgemäßen Ausbildung ferner vor, dass der Halteabschnitt des Hebelelements frei schwingend gegenüber der Rückseite des Bedienelements angeordnet ist. Je nach der gewählten Elastizität des Materials für das Hebelelement ist die Schwingungsamplitude einstellbar. Jedoch ist sichergestellt, dass die Vibration des Vibrationsaktuators von dem Hebelelement aufnehmbar und auf das die Bedienoberfläche stellende Bauteil übertragbar ist. Der Halteabschnitt weist vorzugsweise ein freies Ende auf und ist unbefestigt.

Für eine günstige Einleitung der Vibration in das Hebelelement ist der Vibrationsaktuator flächig an dem Hebelelement anliegend befestigt.

Eine Weiterbildung des Bedienelements ist dadurch gekennzeichnet, dass es auf seiner Vorderseite eine Blende aufweist, welche die Bedienoberfläche bildet. Die Blende ist fugenlos ausgebildet, so dass der lokal begrenzte Abschnitt der Bedienoberfläche ununterbrochen, d.h. nahtlos, fugenlos bzw. mit durchgängiger Oberfläche ausgebildet ist.

Eine Ausführung des Bedienelements ist dadurch gekennzeichnet, dass sich der Halteabschnitt parallel beabstandet zu der Rückseite des Bedienelements erstreckt. Eine alternative Ausführung sieht vor, dass sich der Halteabschnitt senkrecht zu der Rückseite des Bedienelements erstreckt. Die Lage des Halteabschnitts kann somit in Abhängigkeit von dem zur Verfügung stehenden Bauraum benachbart zur Hinterfläche angepasst werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine schematische Ansicht eines ersten Ausführungsbeispiels eines Bedienelements in Seitenansicht und Draufsicht;
- Fig. 2: eine schematische Ansicht eines zweiten Ausführungsbeispiels eines Bedienelements in Seitenansicht und Draufsicht.

Die Figuren sind beispielhaft schematisch und zeigen ein Bedienelement 1 in einer Seitenansicht und Draufsicht, beispielsweise ausgebildet als Verkleidungsteil mit integrierten Aktionstasten als Mensch-Maschine-Schnittstelle, welche bei einer Nutzung ein haptisches Feedback an den Nutzer übermitteln. Die hierfür nötige Elektronik und Sensorik kann aus dem Stand der Technik genutzt werden. Beispielsweise wird ein kapazitiver Sensor eingesetzt.

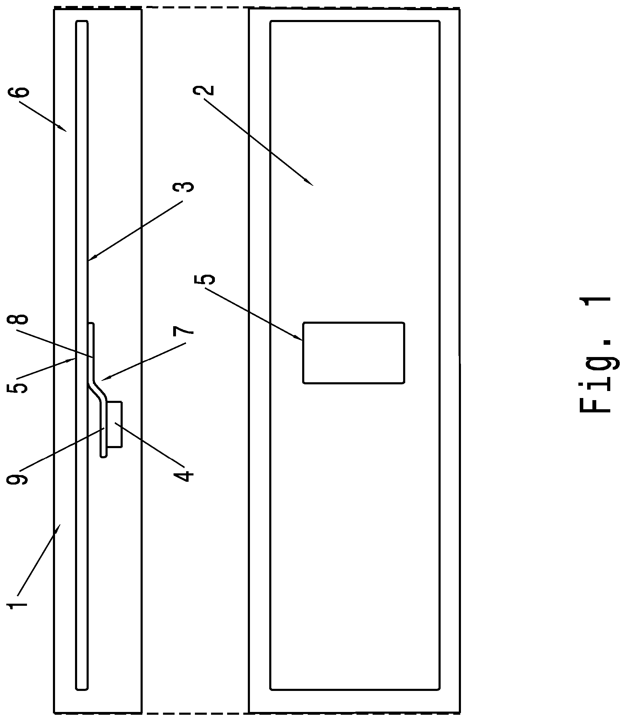

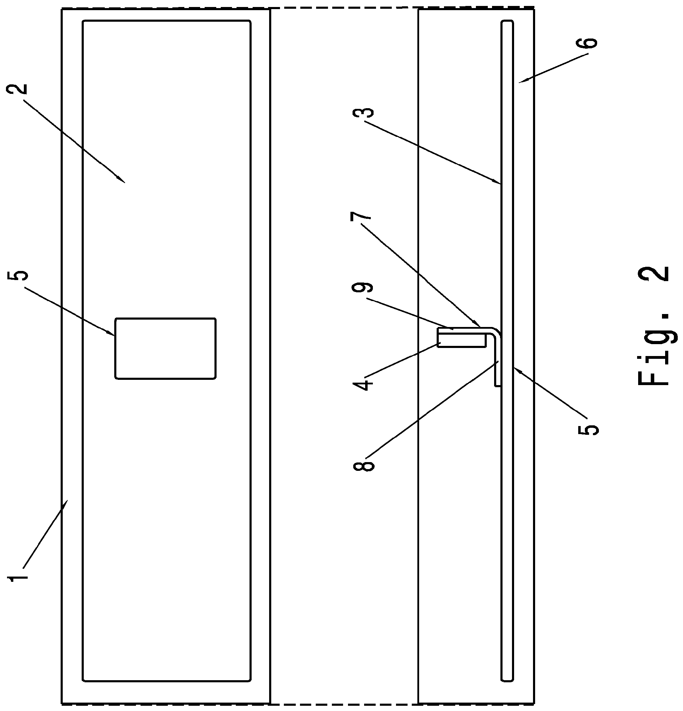

In den Ausführungsbeispielen gemäß Figur 1 und Figur 2 hat das Bedienelement 1 die Bedienoberfläche 2 auf einer Vorderseite und die Hinterfläche 3 auf der gegenüberliegenden Rückseite. Üblicherweise entspricht die Vorderseite der Sichtseite des Bedienelements 1. Die Bedienoberfläche 2 ist beispielhaft gebildet durch eine durchgängige, nahtlose, fugenlose Blende 6, welche beispielhaft den lokal begrenzten Abschnitt 5 aufweist, der als Funktionstaste dient und dessen Nutzung mit einem Vibrationsfeedback hinterlegt ist. Hierzu weist das Bedienelement 1 auf der Rückseite, von der Vorderseite nicht sichtbar den Vibrationsaktuator 4 auf, der über das Hebelelement 7 mit dem lokal begrenzten Abschnitt 5 der Bedienoberfläche 2 wirkverbunden ist, so dass eine über die Sensorik detektierte Berührung des lokal begrenzten Abschnitts 5 der Bedienoberfläche 2 eine Vibration des Vibrationsaktuators 4 auslöst. Die Vibration wird über das Hebelelement 7 auf die Hinterfläche 3, und von dort aus auf den lokal begrenzten Abschnitt 5 der Bedienoberfläche 2 übertragen, von wo aus die Vibration haptisch erfassbar ist.

Das Hebelelement 7 hat einen Anlageabschnitt 8, der geometrisch genau so geformt ist, wie der lokal begrenzte Abschnitt 5 der Bedienoberfläche 2. Beispielhaft ist der lokal begrenzte Abschnitt 5 der Bedienoberfläche 2 als Rechteck dargestellt, es können jedoch beliebige geometrische Formen realisiert sein. Der Anlageabschnitt liegt unmittelbar und flächig an der Hinterfläche 3 an, so dass die Vibration exakt und lokal begrenzt nur im lokal begrenzten Abschnitt 5 der Bedienoberfläche 2 spürbar ist. Über den Anlageabschnitt 8 ist das Hebelelement 7 an der Hinterfläche 3 befestigt, beispielsweise verklebt.

Das Hebelelement 7 ist einstückig geformt und weist neben dem Anlageabschnitt 8 einen Halteabschnitt 9 auf, an dem der Vibrationsaktuator 4 flächig anliegend befestigt gehalten, beispielsweise verschraubt ist. Der Halteabschnitt 9 des Hebelelements 7 ist von der Hinterfläche 3 beabstandet und kann frei schwingen, so dass die Vibrationen des Vibrationsaktuators 4 ausschließlich auf den Halteabschnitt 9 einwirken und nur mittelbar über das Hebelelement 7 auf die Hinterfläche 3 und mithin die Bedienoberfläche 2 im lokal begrenzten Abschnitt 5 übertragen werden.

Im Ausführungsbeispiel gemäß Figur 1 ist das Hebelelement 7 derart ausgestaltet, dass es sich im Wesentlichen parallel zur Hinterfläche 3 erstreckt, wobei der Halteabschnitt 9 durch eine in der Seitenansicht Z-förmige Stufe des Hebelelements 7 von dem Anlagenabschnitt 8 getrennt ist. Somit werden der Abstand des Halteabschnitts 9 zur Hinterfläche und die freie Beweglichkeit des Halteabschnitts 9 sichergestellt.

In Figur 2 erstreckt sich der Halteabschnitt 9 senkrecht zu der Hinterfläche 3 auf der Rückseite des Bedienelements 1. Das Hebelelement 7 bildet somit eine 90-Grad-Umlenkung zwischen dem Anlagenabschnitt 8 und dem Halteabschnitt 9 für den Vibrationsaktuator 4. Neben der gezeigten 90-Grad-Umlenkung sind natürlich auch andere Winkel realisierbar, je nachdem wie der sich anschließende Bauraum ausgebildet ist.

## Patentansprüche

1. Bedienelement (1) mit einer Bedienoberfläche (2) auf einer Vorderseite und einer Hinterfläche (3) auf einer zur Vorderseite gegenüberliegenden Rückseite des Bedienelements, wobei das Bedienelement einen Vibrationsaktuator (4) aufweist, der wirkverbunden ist mit einem lokal begrenzten Abschnitt (5) der Bedienoberfläche (2), wobei
das Bedienelement (1) eingerichtet ist, über eine Sensorik zu detektieren, dass der lokal begrenzte Abschnitt (5) der Bedienoberfläche (2) berührt wird, und infolgedessen eine Vibration des Vibrationsaktuators (4) auszulösen,
wobei der Vibrationsaktuator (4) mittelbar über ein Hebelelement (7) mit der Hinterfläche (3) auf der Rückseite der Bedienoberfläche (2) verbunden ist, wobei das Hebelelement (7) eingerichtet ist, eine Vibration des Vibrationsaktuators (4) zur Hinterfläche (3) des Bedienelements in den Bereich des lokal begrenzten Abschnitts (5) der Vorderseite der Bedienoberfläche (2) zu übertragen,
wobei das Hebelelement (7) einen Anlagenabschnitt (8) aufweist, der zur Anlage an der Rückseite der Bedienoberfläche (2) in dem lokal begrenzten Abschnitt (5) der Bedienoberfläche (2) ausgebildet ist und eine geometrische Abmessung aufweist, die dem lokal begrenzten Abschnitt (5) der Bedienoberfläche (2) entspricht, wobei das Hebelelement (7) einen Halteabschnitt (9) aufweist, an dem der Vibrationsaktuator (4) befestigt gehalten ist, und wobei der Halteabschnitt (9) des Hebelelements (7) frei schwingend gegenüber der Hinterfläche (3) des Bedienelements (1) angeordnet ist.

2. Bedienelement nach Anspruch 1, **dadurch gekennzeichnet, dass** der Anlagenabschnitt (8) flächig anliegend an der Hinterfläche (3) des Bedienelements (1) zugeordnet zu dem lokal begrenzten Abschnitt (5) der Bedienoberfläche (2) befestigt ist.

3. Bedienelement nach einem der vorigen Ansprüche, **dadurch gekennzeichnet, dass** der Vibrationsaktuator (4) zu der Hinterfläche (3) auf der Rückseite beabstandet angeordnet ist und eine Vibration des Vibrationsaktuators (4) unmittelbar ausschließlich auf das Hebelelement (7) einwirkt.

4. Bedienelement nach einem der vorigen Ansprüche, **dadurch gekennzeichnet, dass** der Vibrationsaktuator (4) flächig an dem Hebelelement (7) anliegt.

5. Bedienelement nach einem der vorigen Ansprüche, **dadurch gekennzeichnet, dass** das Bedienelement (1) auf seiner Vorderseite eine Blende (6) aufweist, welche die Bedienoberfläche (2) bildet, und wobei die Blende (6) fugenlos ausgebildet ist, so dass der lokal begrenzte Abschnitt der Bedienoberfläche (2) ununterbrochen ausgebildet ist.

6. Bedienelement nach einem der vorigen Ansprüche 3 bis 4, **dadurch gekennzeichnet, dass** sich der Halteabschnitt (9) parallel beabstandet zu der Rückseite des Bedienelements (1) erstreckt.

7. Bedienelement nach einem der vorigen Ansprüche 3 bis 4, **dadurch gekennzeichnet, dass** sich der Halteabschnitt (9) senkrecht zu der Rückseite des Bedienelements (1) erstreckt.

## Claims

1. A control element (1) with a control panel (2) on a front side and a rear surface (3) on a rear side of the control element situated opposite the front side,
wherein the control element has a vibration actuator (4) which is operatively connected to a locally limited portion (5) of the control panel (2), wherein the control element (1) is configured to detect by means of a sensor system that the locally limited portion (5) of the control panel (2) is being touched and to consequently trigger a vibration of the vibration actuator (4) , wherein the vibration actuator (4) is connected indirectly via a lever element (7) to the rear surface (3) on the rear side of the control panel (2), wherein the lever element (7) is configured to transmit a vibration of the vibration actuator (4) to the rear surface (3) of the control element in the area of the locally limited portion (5) of the front side of the control panel (2), wherein
the lever element (7) has a contact portion (8) which is designed to rest against the rear side of the control panel (2) in the locally limited portion (5) of the control panel (2) and has a geometric dimension that corresponds to the locally limited portion (5) of the control panel (2), wherein the lever element (7) has a holding portion (9) against which the vibration actuator (4) is held fastened, and wherein the holding portion (9) of the lever element (7) is arranged so as to swing freely relative to the rear surface (3) of the control element (1).

2. The control element as set forth in claim 1, **characterized in that** the contact portion (8) is secured so as to lie flat against the rear surface (3) of the control element (1) in association with the locally limited portion (5) of the control panel (2).

3. The control element as set forth in one of the preceding claims, **characterized in that** the vibration actuator (4) is arranged so as to be spaced apart from the rear surface (3) on the rear side, and a vibration of the vibration actuator (4) acts directly exclusively on the lever element (7).

4. The control element as set forth in one of the preceding claims, **characterized in that** the vibration actuator (4) lies flat against the lever element (7).

5. The control element as set forth in one of the preceding claims, **characterized in that** the control element (1) has a cover plate (6) on its front side which forms the control panel (2), the cover plate (6) being seamless so that the locally limited portion of the control panel (2) is continuous.

6. The control element as set forth in one of preceding claims 3 to 4, **characterized in that** the holding portion (9) extends parallel and at a distance from the rear side of the control element (1).

7. The control element as set forth in one of preceding claims 3 to 4, **characterized in that** the holding portion (9) extends perpendicular to the rear side of the control element (1).

## Revendications

1. Élément de manœuvre (1) avec une surface de manœuvre (2) sur un côté avant et une surface arrière (3) sur un côté arrière de l'élément de manœuvre opposé au côté avant, dans lequel l'élément de manœuvre présente un actionneur de vibration (4), qui est relié de manière fonctionnelle à une partie localement délimitée (5) de la surface de manœuvre (2), dans lequel l'élément de manœuvre (1) est conçu pour la détection, par l'intermédiaire d'un système de capteurs, que la partie localement délimitée (5) de la surface de manœuvre (2) est touchée, et par conséquent le déclenchement d'une vibration de l'actionneur de vibration (4), dans lequel l'actionneur de vibration (4) est raccordé indirectement par l'intermédiaire d'un élément de levier (7) à la surface arrière (3) sur le côté arrière de la surface de manœuvre (2), dans lequel l'élément de levier (7) est conçu pour la transmission d'une vibration de l'actionneur de vibration (4) vers la surface arrière (3) de l'élément de manœuvre dans la zone de la partie localement délimitée (5) du côté avant de la surface de manœuvre (2), dans lequel l'élément de levier (7) présente une partie d'appui (8), qui est réalisée pour l'appui sur le côté arrière de la surface de manœuvre (2) dans la partie localement délimitée (5) de la surface de manœuvre (2) et présente une dimension géométrique, qui correspond à la partie localement délimitée (5) de la surface de manœuvre (2), dans lequel l'élément de levier (7) présente une partie de maintien (9), sur laquelle l'actionneur de vibration (4) est maintenu fixé, et dans lequel la partie de maintien (9) de l'élément de levier (7) est agencée en oscillant librement par rapport à la surface arrière (3) de l'élément de manœuvre (1).

2. Élément de manœuvre selon la revendication 1, **caractérisé en ce que** la partie d'appui (8) est fixée en appui à plat sur la surface arrière (3) de l'élément de manœuvre (1) associée à la partie localement délimitée (5) de la surface de manœuvre (2).

3. Élément de manœuvre selon l'une des revendications précédentes, **caractérisé en ce que** l'actionneur de vibration (4) est agencé à distance de la surface arrière (3) sur le côté arrière et une vibration de l'actionneur de vibration (4) agit directement exclusivement sur l'élément de levier (7).

4. Élément de manœuvre selon l'une des revendications précédentes, **caractérisé en ce que** l'actionneur de vibration (4) s'appuie à plat sur l'élément de levier (7).

5. Élément de manœuvre selon l'une des revendications précédentes, **caractérisé en ce que** l'élément de manœuvre (1) présente sur son côté avant un cache (6), qui forme la surface de manœuvre (2), et dans lequel le cache (6) est réalisé sans joint, de sorte que la partie localement délimitée de la surface de manœuvre (2) est réalisée de manière ininterrompue.

6. Élément de manœuvre selon l'une des revendications précédentes 3 à 4, **caractérisé en ce que** la partie de maintien (9) s'étend parallèlement à distance du côté arrière de l'élément de manœuvre (1).

7. Élément de manœuvre selon l'une des revendications précédentes 3 à 4, **caractérisé en ce que** la partie de maintien (9) s'étend perpendiculairement au côté arrière de l'élément de manœuvre (1).
